# EUROPÄISCHE PATENTSCHRIFT

(11) **EP 4 369 343 B1**
(45) Veröffentlichungstag und Bekanntmachung des Hinweises auf die Patenterteilung: **26.08.2026**
(21) Anmeldenummer: 22206722.5
(22) Anmeldetag: 10.11.2022
(51) Int. Cl.: G11C 16/34, G11C 7/20, G11C 29/44

(54) **VERFAHREN ZUM AUSLESEN VON DIAGNOSEDATEN AUS VERSCHIEDENEN SPEICHERN**
METHOD FOR READING DIAGNOSTIC DATA FROM DIFFERENT MEMORIES
PROCÉDURE DE LECTURE DES DONNÉES DE DIAGNOSTIC DE DIFFÉRENTES MÉMOIRES

(43) Veröffentlichungstag der Anmeldung: 15.05.2024
(73) Patentinhaber: Siemens Aktiengesellschaft, 80333 München (DE)
(72) Erfinder: Horak, Thomas, 16766 Kremmen (DE)
(74) Vertreter: Siemens Patent Attorneys

(56) Entgegenhaltungen:
- DE-A1- 102008 061 093

## Beschreibung

Die Erfindung bezieht sich auf einen Speicher, der zum Anschluss an elektrische Geräte geeignet ist. Bei dem Speicher kann es sich beispielsweise um einen nichtflüchtigen Speicher wie zum Beispiel einen Flash-Speicher handeln. Derartige Speicher sind in Form von SD-Speicherkarten allgemein erhältlich.

Der auf SD-Speicherkarten verwendete sogenannte NAND-Flash hat eine begrenzte Lebensdauer, da er sich nicht beliebig oft löschen lässt. Wenn SD-Karten als technisches Bauteil in Geräten für industrielle Anwendungen mit hohen Anforderungen an die Verfügbarkeit eingesetzt werden, kann die Notwendigkeit bestehen, Informationen über den Gesundheitszustand der SD-Karte als Diagnoseinformationen zu gewinnen und auszuwerten. Das Ziel besteht darin, einen bevorstehenden Ausfall einer SD-Karte rechtzeitig zu diagnostizieren, um im Zuge einer planmäßigen Wartung die vom Ausfall bedrohte SD-Karte ersetzen zu können.

SD-Karten für industriellen Einsatzzweck bieten daher oft die Möglichkeit, über den Speicherbus mittels SD/MMC-Protokoll auf vom Hersteller des Controllers bereitgestellte Diagnosedaten zuzugreifen. Die Art und Weise, wie diese Diagnosedaten ausgelesen werden können, sowie das Format und die Inhalte der Diagnosedaten sind nicht genormt und werden von den Herstellern der SD-Kartencontroller auf unterschiedliche Weise umgesetzt.

Für jeden unterstützten SD-Kartentyp muss daher im Allgemeinen eine dazu passende Implementierung in der Treibersoftware der Geräte erfolgen. Kommen unterschiedliche SD-Kartentypen zu Einsatz, muss der Typ der gesteckten SD-Karte im Gerät automatisch erkannt und die passenden Programmroutinen für die Diagnose ausgeführt werden.

Sollen neue Typen von SD-Karten eingeführt werden, weil die für ein Gerät qualifizierten Varianten beispielsweise von ihren Herstellern abgekündigt wurden, muss die Gerätesoftware für den Zugriff auf die Diagnosedaten neuer SD-Kartentypen angepasst werden. Dies würde bei den Geräten mit langer Lebensdauer im Feld immer dann einen Softwareaustausch erzwingen, wenn eine der neuen SD-Kartentypen als Ersatzteil für eine vom Ausfall bedrohte ältere SD-Karte eingesetzt werden muss.

Ein Tausch der Gerätesoftware kann jedoch Probleme bereiten, zum Beispiel
- wenn es sich um eine Vielzahl von - eventuell weltweit - eingesetzten Geräten mit unterschiedlich alten Softwareständen in heterogenen Anlagensituationen und sich daraus ergebenden Kompatibilitätsproblemen handelt und/oder
- wenn es sich um Geräte ohne direkte Möglichkeit zum Einspielen neuer Software oder mit eingeschränktem Zugang handelt und/oder
- wenn die Geräte beispielsweise auf Kundenanlagen in sicherheitskritischen Anwendungen eingesetzt werden und neue Softwarestände zunächst umfangreichen zusätzlichen und kostenintensiven Prüfungen unterzogen werden müssten und/oder
- wenn Kunden das Einspielen neuer Gerätesoftware aus anderen Gründen nicht wünschen.

Aus der DE 10 2008 061093 A1 ist Verfahren zum Initialisieren eines Speichers bekannt geworden, der über einen Informationsdatensatz (IDS) verfügt. Der besagte Informationsdatensatz umfasst Informationen über das erforderliche Anfrageprozedere für externen Anfragen. So sind in einem Typenkennungsabschnitt zur Implementierung eines Speicherzugriffes erforderliche und für den Speicher spezifische und charakteristische Daten abgespeichert. Darüber hinaus werden Auswertinformationen bereitgestellt, die eine Interpretation der vom Speicher auf Anfrage gelieferten Antwortdaten ermöglichen.

Der Erfindung liegt die Aufgabe zugrunde, die Nutzbarkeit von speicherspezifischen Diagnosedaten für die Umgebung des Speichers zu gewährleisten.

Diese Aufgabe wird erfindungsgemäß durch ein Verfahren mit den Merkmalen gemäß Patentanspruch 1 gelöst, sowie durch ein Gerät nach Anspruch 2, das eine Schnittstelle zum Anschluss an einen Speicher aufweist. Vorteilhafte Ausgestaltungen des erfindungsgemäßen Speichers sind in Unteransprüchen angegeben.

Bezüglich eines solchen Initialisierungsverfahrens ist erfindungsgemäß vorgesehen, dass ein auf dem Speicher gespeicherter Informationsdatensatz ausgelesen und interpretiert wird, der folgende Informationen enthält: Informationen über die Art an Diagnosedaten, die der Speicher bei externer Anfrage zur Verfügung stellt, Informationen über das erforderliche Anfrageprozedere für solche externen Anfragen und Auswertinformationen, die eine Interpretation der vom Speicher auf Anfrage gelieferten Antwortdaten ermöglichen.

Bezüglich der Vorteile des erfindungsgemäßen Verfahrens und dessen vorteilhafter Ausgestaltungen sei auf die obigen Ausführungen im Zusammenhang mit dem erfindungsgemäßen Speicher und dessen vorteilhafter Ausgestaltungen verwiesen.

Die Erfindung bezieht sich außerdem auf ein Gerät, das eine Schnittstelle zum Anschluss an einen Speicher, insbesondere einen Speicher, wie er oben beschrieben worden ist, aufweist. Bezüglich eines solchen Geräts ist erfindungsgemäß vorgesehen, dass in dem Gerät ein Interpretationssoftwaremodul abgespeichert ist, das bei Ausführung durch eine Recheneinrichtung des Geräts das Gerät veranlasst, einen in einem angeschlossenen Speicher abgespeicherten Informationsdatensatz, der Informationen über die Art an Diagnosedaten, die der Speicher bei externer Anfrage zur Verfügung stellt, Informationen über das erforderliche Anfrageprozedere für solche externen Anfragen und Auswertinformationen, die eine Interpretation der vom Speicher auf Anfrage gelieferten Antwortdaten ermöglichen, enthält, auszulesen und zumindest hinsichtlich des Anfrageprozedere und der Interpretation der Antwortdaten auszuwerten.

Bezüglich der Vorteile des erfindungsgemäßen Geräts und dessen vorteilhafter Ausgestaltungen sei auf die obigen Ausführungen im Zusammenhang mit dem erfindungsgemäßen Speicher und dessen vorteilhafter Ausgestaltungen verwiesen.

Ein wesentlicher Vorteil des erfindungsgemäßen Geräts besteht in der durch das Interpretationssoftwaremodul möglichen automatisierten Anpassung der Gerätearbeitsweise an die jeweiligen Speichereigenschaften, wenn es darum geht, Diagnosedaten aus dem Speicher auszulesen und zu interpretieren bzw. speicherindividuell Maßnahmen zu ergreifen, wenn der Speicher einen kritischen Zustand erreicht.

Von Vorteil ist es, wenn das Interpretationssoftwaremodul Bitsequenzen oder eine Anfragebefehlskette aus dem Informationsdatensatz ausliest und diese anschließend abarbeitet, um die Diagnosedaten aus dem Speicher abzufragen.

Auch ist es vorteilhaft, wenn das Interpretationssoftwaremodul aus dem Informationsdatensatz Interpretationsinstruktionen ausliest und diese anschließend abarbeitet, um die ausgelesenen Diagnosedaten zu interpretieren und speicherseitig empfohlene Maßnahmen durchzuführen.

Vorzugsweise liest das Interpretationssoftwaremodul einen fest vorgegebenen Speicherort des Speichers aus und behandelt die dort abgespeicherten Daten als den Informationsdatensatz weiter. Eine Vorabkenntnis über den Speicher ist bei dieser Vorgehensweise in vorteilhafter Weise nicht erforderlich.

Besonders vorteilhaft ist es, wenn das Interpretationssoftwaremodul des Geräts einen oder mehrere Funktionsblöcke, die die Informationen über das erforderliche Anfrageprozedere, also zum Beispiel die Anfragebefehlskette, und die Auswertinformationen, also zum Beispiel die Instruktionsbefehlskette, enthalten, aus dem Speicher ausliest und in einen Speicherkommunikationsabschnitt des Interpretationssoftwaremoduls zum Beispiel durch Reinkopieren der Funktionsblöcke integriert; in dieser Weise kann die Anpassung bzw. Adaption des Interpretationssoftwaremoduls an den individuellen Speicher im Rahmen eines einfachen Kopierschritts vollendet werden.

Bei bedienerseitiger Aufforderung gibt das Gerät vorzugsweise Beschreibungsinformationen des Informationsdatensatzes visuell, haptisch und/oder akustisch aus. Auch ermöglicht das Gerät vorzugsweise eine Fernabfrage der Beschreibungsinformationen.

Bei dem Gerät handelt es sich vorzugsweise um ein energietechnisches Schutz- und/oder Beobachtungsgerät, insbesondere ein Leittechnikgerät, einen Störschreiber oder eine Einrichtung zur Überwachung der Netzqualität, für eine elektrische Energieversorgungsanlage.

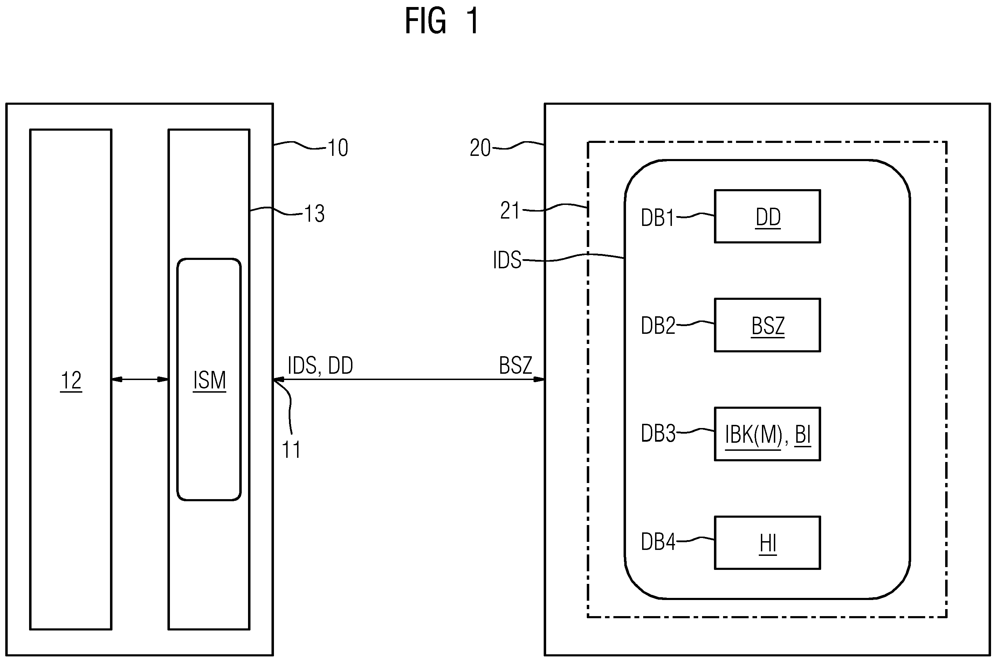

Die Erfindung wird nachfolgend anhand von Ausführungsbeispielen näher erläutert, dabei zeigen beispielhaft
- Figur 1: ein erstes Ausführungsbeispiel für eine Anordnung, die mit einem Ausführungsbeispiel für ein erfindungsgemäßes Gerät und einem Ausführungsbeispiel für einen an das Gerät angeschlossenen Speicher ausgestattet ist, wobei in dem Speicher abgespeicherte Informationen über ein erforderliches Anfrageprozedere eine oder mehr Bitsequenzen umfasst,

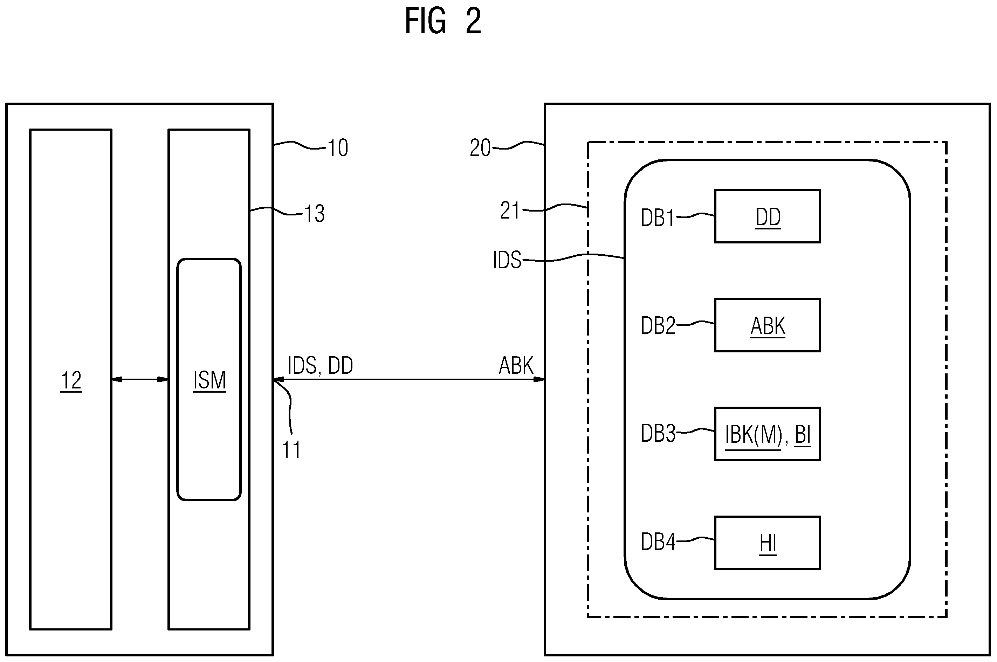

- Figur 2: als zweites Ausführungsbeispiel eine Ausführungsvariante des ersten Ausführungsbeispiels, bei der Informationen über das erforderliche Anfrageprozedere eine vollständige Anfragebefehlskette definieren, die ein Interpretationssoftwaremodul des Geräts nach dem Laden des Informationsdatensatzes direkt anwenden und unmittelbar abarbeiten kann, und

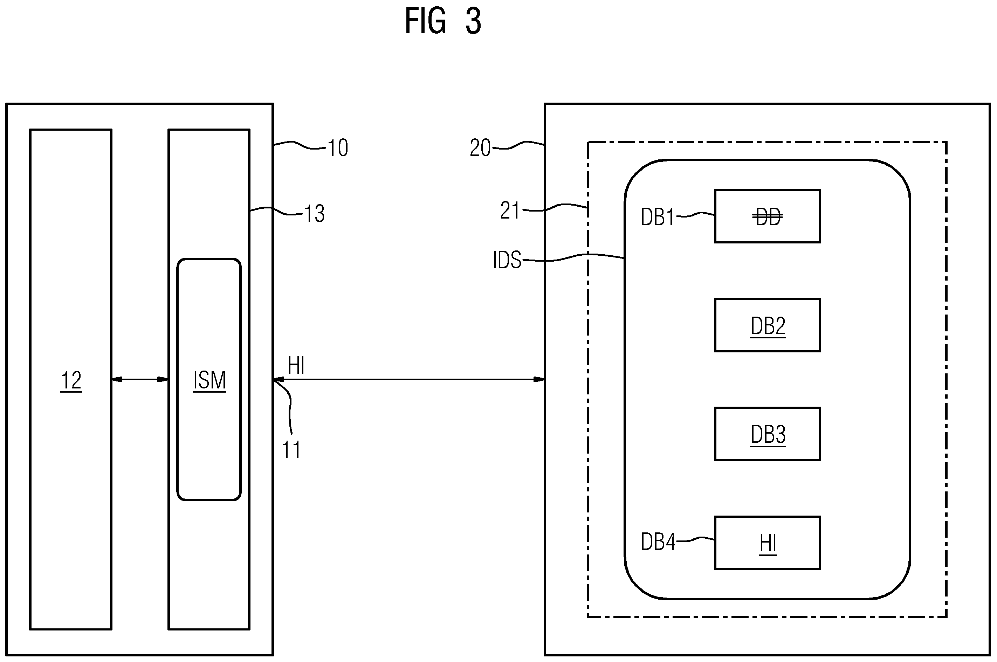

- Figur 3: als drittes Ausführungsbeispiel eine Ausführungsvariante, bei der der Speicher aus technischen Gründen kein Auslesen von Diagnosedaten ermöglicht, aber Hilfsinformationen zur Verfügung stellt, die eine Hilfsabschätzung der Lebensdauer des Speichers ermöglichen.

In den Figuren werden der Übersicht wegen für identische oder vergleichbare Komponenten stets dieselben Bezugszeichen verwendet.

Die Figur 1 zeigt ein Ausführungsbeispiel für eine Anordnung mit einem Gerät 10 und einen an einer Schnittstelle 11 des Geräts 10 angeschlossenen Speicher 20.

Bei dem Speicher 20 handelt es sich vorzugsweise um einen nichtflüchtigen Flash-Speicher. Bei dem Gerät 10 handelt es sich vorzugsweise um ein energietechnisches Schutz- und/oder Beobachtungsgerät, insbesondere ein Leittechnikgerät, einen Störschreiber oder eine Einrichtung zur Überwachung der Netzqualität für eine elektrische Energieversorgungsanlage.

In dem Speicher 20 ist ein Informationsdatensatz IDS abgespeichert, den das Gerät 10 auslesen und auswerten kann, um nachfolgend Diagnosedaten DD, wie beispielsweise die Lebensdauer oder den technischen Zustand des Speichers 20 betreffende Angaben, aus dem Speicher 20 auslesen und auswerten zu können. Vorteilhaft ist es, wenn der Speicher 20 als Diagnosedaten DD den Löschzyklenzählerstand, die Anzahl an noch verfügbaren Reserveblöcken und/oder die Restlebensdauer des Speichers 20 zur Verfügung stellt. Der Informationsdatensatz IDS ist vorzugsweise an einer fest vordefinierten Speicherstelle 21 bzw. Speicherabschnitt des Speichers 20 abgespeichert.

Der Informationsdatensatz IDS gemäß Figur 1 enthält einen ersten Datensatzbereich DB1 mit Informationen über die Art an Diagnosedaten DD, die der Speicher 20 bei geeigneter externer Anfrage dem angeschlossenen Gerät 10 zur Verfügung stellen kann.

In einem zweiten Datensatzbereich DB2 des Informationsdatensatzes IDS gemäß Figur 1 sind Informationen über das erforderliche Anfrageprozedere für geeignete externe Anfragen durch das Gerät 10 beschrieben.

Die in dem zweiten Datensatzbereich DB2 des Informationsdatensatzes IDS abgespeicherten Informationen über das erforderliche Anfrageprozedere können in unterschiedlicher Weise ausgestaltet sein.

Beispielsweise können, wie die Figur 1 beispielhaft zeigt, die Informationen über das erforderliche Anfrageprozedere eine oder mehr Bitsequenzen BSZ, auf die der Speicher 20 mit der Ausgabe der Diagnosedaten DD reagiert, umfassen. Das Gerät 10 kann diese Bitsequenzen BSZ nach Empfang des Informationsdatensatzes IDS in Eigenregie verwenden, um die Diagnosedaten DD aus dem Speicher 20 auszulesen.

Alternativ oder zusätzlich können die Informationen über das erforderliche Anfrageprozedere, wie beispielhaft die Figur 2 zeigt, eine vollständige Anfragebefehlskette ABK definieren, die ein Interpretationssoftwaremodul ISM des Geräts 10 nach dem Laden des Informationsdatensatzes IDS direkt anwenden bzw. unmittelbar abarbeiten kann, um die Diagnosedaten DD aus dem Speicher 20 abzufragen.

Ein dritter Datensatzbereich DB3 des Informationsdatensatzes IDS enthält Auswertinformationen, die eine Interpretation der vom Speicher 20 auf Anfrage gelieferten Antwortdaten ermöglichen.

Die in dem dritten Datensatzbereich DB3 des Informationsdatensatzes IDS abgespeicherten Auswertinformationen umfassen vorzugsweise das Datenformat, die Datenstruktur und/oder die Bitanordnung der Antwortdaten, die der Speicher 20 ausgibt, und befähigen somit das Gerät 10, vom Speicher 20 kommende Daten zu verstehen.

Beispielsweise können die in dem dritten Datensatzbereich DB3 des Informationsdatensatzes IDS abgespeicherten Auswertinformationen konkrete Interpretationsinstruktionen in Form eines Interpretations-Algorithmus oder einer Interpretationsbefehlskette IBK enthalten, den bzw. die das Interpretationssoftwaremodul ISM des Geräts 10 unmittelbar ausführen kann, um die Interpretation der ausgelesenen Diagnosedaten DD vorzunehmen.

Die Interpretationsinstruktionen (also der Interpretations-Algorithmus bzw. die Interpretationsbefehlskette IBK) enthalten vorzugsweise außerdem speicherseitig empfohlene Maßnahmen M, die das Gerät 10 durchführen sollte, wenn der Zustand des Speichers 20 kritisch wird bzw. der Speicher 20 seine Lebensdauergrenze erreicht. Solche Maßnahmen umfassen beispielsweise das Erzeugen von Warn- oder Alarmsignalen, wenn die Diagnosedaten DD kritische Werte erreichen oder Schwellenwerte überschreiten oder unterschreiten.

Besonders vorteilhaft ist es, wenn die Interpretationsbefehlskette IBK die Anfragebefehlskette ABK ergänzt bzw. sich an diese anschließt. Bei einer solchen Ausgestaltung kann das Interpretationssoftwaremodul ISM zunächst die Anfragebefehlskette ABK und anschließend die Interpretationsbefehlskette IBK abarbeiten sowie ggf. die in der Interpretationsbefehlskette IBK definierten Maßnahmen M wie zum Beispiel das Erzeugen von Warn-, Wartungs- oder Alarmsignalen in Abhängigkeit von den empfangenen Diagnosedaten DD durchführen.

Die Anfragebefehlskette ABK und die Instruktionsbefehlskette IBK können jeweils als kopierbare Funktionsblöcke abgespeichert sein, die das angeschlossene Gerät 10 auslesen und in sein Interpretationssoftwaremodul ISM zum Beispiel durch Reinkopieren der Funktionsblöcke implementieren kann; in dieser Weise kann die Anpassung bzw. Adaption des Interpretationssoftwaremoduls an den individuellen Speicher im Rahmen eines einfachen Kopierschritts bereits vollendet werden.

Beispielsweise kann das Gerät 10, nachdem es die Diagnosedaten DD, wie zum Beispiel die Anzahl der Ersatzspeicherblöcke, die Anzahl der Löschzyklen und/oder einen die Haltbarkeit (Restlebensdauer) beschreibenden Haltbarkeitswert aus dem Speicher 20 ausgelesen hat, im Rahmen der genannten Maßnahmen M die ausgelesenen Werte mit vorgegebenen Schwellenwerten vergleichen und je nach dem Vergleichsergebnis und den herangezogenen Schwellenwerten die genannten Warn- oder Alarmsignale erzeugen.

Der dritte Datensatzbereich DB3 des Informationsdatensatzes IDS kann darüber hinaus Beschreibungsinformationen BI in menschlich interpretierbarer Textform enthalten, die eine bedienerseitige Interpretation der vom Speicher 20 gelieferten Diagnosedaten DD ermöglichen.

Falls der Speicher 20 aus technischen Gründen kein Auslesen von Diagnosedaten DD ermöglicht, wie beispielhaft die Figur 3 zeigt, so werden in dem Informationsdatensatz IDS vorzugsweise Hilfsinformationen HI abgespeichert, die zumindest eine Hilfsabschätzung der Lebensdauer des Speichers 20 ermöglichen. Solche Hilfsinformationen HI können das Herstellungsdatum des Speichers 20, die Herstellungscharge und/oder die garantierte Mindestanzahl an Löschvorgängen umfassen. Die Hilfsinformationen HI können in einem eigenen vierten Datensatzbereich DB4 des Informationsdatensatzes IDS abgespeichert sein; in einem solchen Falle kann beispielsweise der erste Datensatzbereich DB1 angeben, dass keine Diagnosedaten DD zur Verfügung stehen, und der zweite und dritte Datensatzbereich DB2 und DB3 können angeben, dass mangels vorhandener Diagnosedaten DD auch kein Anfrageprozedere und demgemäß auch keine diesbezüglichen Auswertinformationen zur Verfügung stehen.

Das in den Figuren 1 bis 3 an den Speicher 20 angeschlossene Gerät 10 umfasst eine Recheneinrichtung 12 und eine geräteseitige Speichereinrichtung 13, in der das bereits erwähnte Interpretationssoftwaremodul ISM abgespeichert ist. Bei Ausführung des Interpretationssoftwaremoduls ISM durch die Recheneinrichtung 12 wird die Recheneinrichtung 12 und damit das Gerät 10 insgesamt befähigt, den Informationsdatensatz IDS aus dem an der Schnittstelle 11 angeschlossenen Speicher 20 auszulesen und auszuwerten, nachfolgend geeignete Diagnoseanfragen an den Speicher 20 zu richten sowie als Antwort auf Diagnoseanfragen empfangene Diagnosedaten DD zu verstehen und zu interpretieren. Alternativ kann das Gerät 10 etwaig vorhandene Hilfsdaten HI - wie in Figur 3 gezeigt - auslesen und auswerten, wenn der Speicher 20 keine Diagnosedaten DD zur Verfügung stellt.

Das Interpretationssoftwaremodul ISM liest zum Zwecke des Erhalts des Informationsdatensatzes IDS vorzugsweise den fest vorgegebenen Speicherort 21 des Speichers 20 aus und behandelt die dort abgespeicherten Daten als Informationsdatensatz IDS weiter.

Beschreibungsinformationen BI, die beispielsweise in dem dritten Datensatzbereich DB3 des Informationsdatensatzes IDS enthalten sind, werden von dem Gerät 10 nach dem Auslesen des Informationsdatensatzes IDS beispielsweise visuell auf einem Bildschirm oder dergleichen ausgegeben. Das Gerät 10 ermöglicht vorzugsweise auch eine Fernabfrage sowohl der Diagnosedaten DD als auch der Beschreibungsinformationen BI des Informationsdatensatzes IDS.

Zur Inbetriebnahme der in den Figuren 1 bis 3 gezeigten Anordnung wird vorzugsweise wie folgt vorgegangen:
Zunächst wird der Speicher 20 initialisiert, indem ein den Speicher 20 beschreibender Informationsdatensatz IDS an dem Speicherort 21 abgespeichert wird. Vorher, gleichzeitig oder danach wird das Interpretationssoftwaremodul ISM in dem Gerät 10 installiert.

Anschließend kann der Speicher 20 an die Schnittstelle 11 des Geräts 10 angeschlossen werden. Nach dem Anschließen kann das Interpretationssoftwaremodul ISM einen oder mehrere Funktionsblöcke, die die Informationen über das erforderliche Anfrageprozedere, also zum Beispiel die Anfragebefehlskette ABK, und die Auswertinformationen, also zum Beispiel die Instruktionsbefehlskette IBK, enthalten, aus dem Speicher 20 auslesen und in einen Speicherkommunikationsabschnitt des Interpretationssoftwaremoduls ISM zum Beispiel durch Reinkopieren der Funktionsblöcke integrieren; in dieser Weise kann die Anpassung bzw. Adaption des Interpretationssoftwaremoduls ISM an den individuellen Speicher 20 im Rahmen eines einfachen Kopierschritts vollendet werden.

Der Informationsdatensatz IDS und das Interpretationssoftwaremodul ISM ermöglichen es dem Gerät 10, regelmäßig oder unregelmäßig aktuelle Statusinformationen über den Zustand des Speichers 20 abzufragen, sofern der Speicher 20 Diagnosedaten DD übermittelt, oder zumindest eine Hilfsschätzung des Status des Speichers 20 anhand von Hilfsinformationen HI vorzunehmen.

Die im Zusammenhang mit den Figuren 1 bis 3 erläuterten Ausführungsbeispiele können in vorteilhafter Weise die nachfolgend beispielhaft sehr detailliert beschriebenen Merkmale und Eigenschaften aufweisen; dabei wird nachfolgend beispielhaft von einem NAND-Flash-Speicher in Form einer SD-Karte ausgegangen:
Das oben beschriebene Interpretationssoftwaremodul ISM kann die Restlebensdauer der SD-Karte auf unterschiedliche Weise abschätzen, zum Beispiel gemäß:

### 1. Ersatzspeicherblöcke ("spare blocks"):

NAND-Flash-Speicher werden bereits bei der Herstellung in aller Regel einige defekte Speicherblöcke aufweisen. Daher wird ein Pool von Ersatzspeicherblöcken definiert, aus denen sich der SD-Kartencontroller bedienen kann, um während des Betriebs defekte gegen funktionierende Speicherblöcke auszutauschen. In einer frühen Phase der Verwendung des NAND-Flashs wird ein gewisser Teil dieser Ersatzspeicherblöcke bereits aufgebraucht. Danach bleibt die Anzahl der noch verfügbaren Ersatzspeicherblöcke über die gesamte Lebenszeit des NAND-Flashs konstant bzw. sinkt nur langsam. Gegen Ende der Lebensdauer, wenn es zu ersten Ausfällen von Speicherzellen aufgrund der Abnutzung durch die Löschzyklen kommt, verkleinert sich der Pool der verbliebenen Ersatzspeicherblöcke in immer schnellerer Folge. Daraus kann auf einen bevorstehenden Ausfall des NAND-Flashs geschlussfolgert werden.

### 2. Löschzyklen ("erase count"):

Für derzeitige 32nm-NAND-Flash-Speicher werden meist mindestens zwischen 1000 und 100000 Löschzyklen garantiert, bis sich eine Speicherzelle nicht mehr fehlerfrei löschen lässt. Anhand eines Zählers für die Löschzyklen lässt sich die Restlebensdauer abschätzen. Dazu sollte für den auf der SD-Karte verwendeten NAND-Flashtyp die maximale Anzahl der Löschzyklen bekannt sein oder als Parameter aus den Diagnosedaten DD hervorgehen.

### 3. Haltbarkeit ("endurance"):

Sofern ein Wert für die Haltbarkeit bereitgestellt wird, handelt es sich meist um einen Prozentwert, der im Laufe der Lebensdauer des Flashs von 100% auf 0% herunterzählt.

Um eine Ausfallwarnung bei hinreichend langer verbleibender Restlaufzeit zu generieren, eignet sich die Prüfung der Anzahl der Löschzyklen (erase count) oder - sofern verfügbar - der Haltbarkeitsangabe (endurance) besser, während die Überwachung der Ersatzspeicherblöcke (spare blocks) einen unmittelbar bevorstehenden Ausfall erkennt und als Ausfallalarm gemeldet werden sollte. Für die dafür benötigten Diagnoseinformationen DD sollte bekannt sein, an welcher Position im Diagnosedatenblock sie sich befinden und wie hoch ihre Grenzwerte sein sollten, die überwacht werden müssen. Es gibt Hersteller, die darüber hinaus sogar einen Algorithmus zur Berechnung der Restlebensdauer auf Basis der Diagnoseinformationen vorgeben.

Nachfolgend sind Beispiele für die Formate von Diagnoseinformationen unterschiedlicher Hersteller ("Vendor 1" bis "Vendor 4") anonymisiert aufgeführt und das Kommando des SD/MMC-Protokolls benannt, mit dem die Datenstrukturen letztlich ausgelesen werden. Die Diagnosedaten, die sich für eine Abschätzung des Gesundheitszustandes der entsprechenden SD-Karten verwenden lassen, sind durch Unterstreichung hervorgehoben:

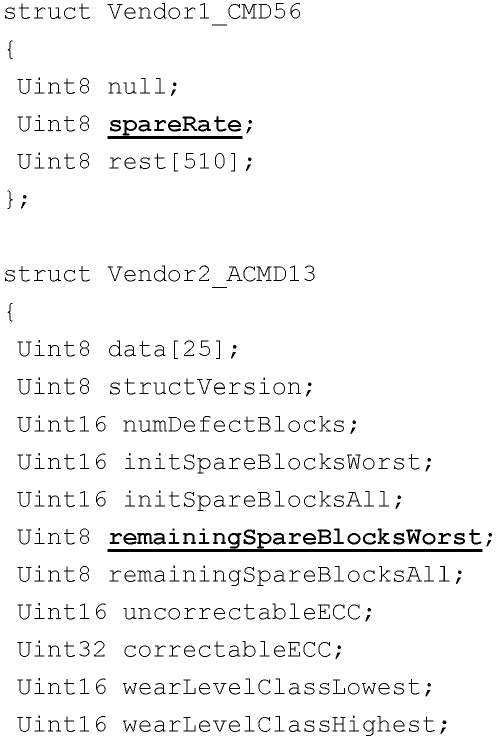

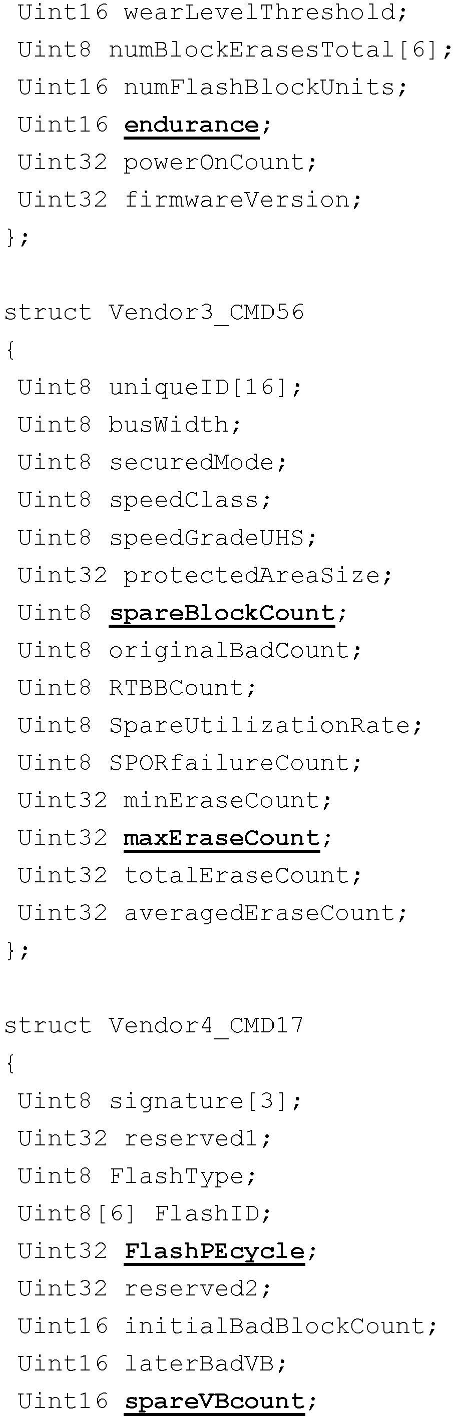

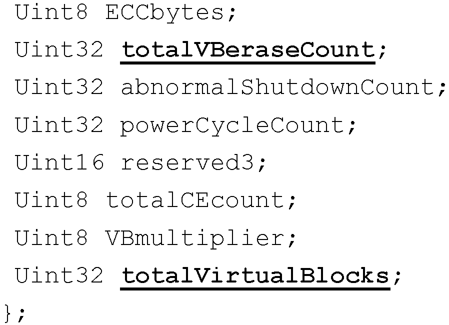

Zur Erstellung des Informationsdatensatzes IDS wird vorzugsweise eine Datenstruktur mit nachfolgend beschriebenem Schema (in computerinterpretierbarer Form) im Zuge eines Autorisierungs-/Produktionsschritts mit den zum entsprechenden SD-Kartentyp passenden Datenbeschreibungen gefüllt und in einen reservierten Sektor als der oben genannten Speicherstelle 21 auf die SD-Karte kopiert:

```
 struct // packet struct, little endianness
 {
  Uint32 authorizationID; // authorization ID, encrypted mark-
 er
  const Uint8 magic[] // for internal use
 = {0, 0, 0, 0};

  Uint32 structChkSum; // checksum over the following struc-
 ture elements
  const Uint8 structVersion =
  1; // structure version to define the used format
  Uint32 warningFromXxGB; // to generate warning, if data
 written to SD card are greater than this
  // value (as fallback solution if diagnostic data are not
 available)
  Uint8 sdCardNameLength;
  char sdCardName[]; // SD card type name for diagnostic text
 page in device
  Uint8 numHealthDataDescs; // => bit 0 ... 6; bit 7: 1 = big-
 endian, 0 = little-endian
  struct
  {
  Uint8 numValues;
  struct
  {
  unsigned index : 9; // index of value in answer buffer
  unsigned type : 3; // 0 = signed, 1 = unsigned, 2 = byte ar-
 ray, 3 = text string
  unsigned dataLength : 4; // length of health value type in
 bytes
  Uint8 nameLength;
  char name[]; // symbolic name of value, for diagnostic page
  } values[];
  } healthDataDescs[]; // one description for every used SD
 command, max. 4
  Uint8 numWritePatterns; // 0 => no patterns for sector
 writes defined
  struct
  {
  Uint16 patternLength;
  Uint8 pattern[]; // compressed
  } writePatterns[];
  Uint16 programCodeLength; // length of the following program
 code
  Uint8 programCode[]; // byte array containing the program
 code for health state calculation
 } diagnosticDataDescriptionBlock;
```

Mit dieser beispielhaften generischen Struktur lassen sich alle im vorherigen Abschnitt als Beispiel aufgeführten herstellerspezifischen Diagnosedaten DD und alle weiteren in diesem Kontext denkbaren Datenformate - einschließlich der Parameternamen als Text - beschreiben. Die Hinterlegung der Parameternamen als Text ermöglicht, aus den Diagnoseinformationen der SD-Karte im Gerät 10 lesbare Textseiten für den Servicetechniker zu generieren.

Die eigentliche Abschätzung der Gesundheit bzw. der verbleibenden Lebensdauer der SD-Karte erfolgt innerhalb des Programmcodes, der vorzugsweise als Bytearray "programCode" (siehe letzter Teil der obigen generischen Struktur) Teil der Datenbeschreibung ist.

Eine diesen Ausführungen zugrunde liegende Beispiel-Implementierung hat gezeigt, dass die Größe eines einzelnen Sektors von 512 Bytes für die Speicherung dieses Beschreibungsblocks hinreichend ist. Die Beschränkung auf einen einzelnen Sektor ist jedoch nicht zwingend.

Bezüglich des Interpretationssoftwaremoduls ISM ist es von Vorteil, wenn eine interpretativ abzuarbeitende Programmiersprache eingesetzt wird, die auf diesen Anwendungsfall zugeschnitten mit wenigen Bytes Programmcode auskommt und im Gegensatz zu direkt ladbaren Maschinencodes kein Einfallstor für Schadsoftware zu bietet. Eine solche Ausgestaltung des Interpretationssoftwaremoduls ISM kann beispielsweise folgende Form aufweisen:
- Eine Programminstruktion besteht aus einem 8bit Instruktionscode, optional gefolgt von einem oder mehreren Argument-Bytes
- Arithmetische und logische Instruktionen haben als Ziel immer die Zuweisung in eines der 8 verfügbaren Register R0 ... R7
- Jedes dieser Register kann einen vorzeichenbehafteten 64bit-Ganzzahlwert speichern
- Als Quelle für Registerzuweisungen sind konstante Ganzzahlwerte, Register und Werte aus Diagnosedatenblöcken möglich. Zusätzlich lassen sich Schreibmuster, Sprungziele (Offsets) und Texte definieren.

### Quellargumente:

a. Konstanter Ganzzahlwert:
   Bit 7 ... 6: 00
   Bit5: 0 = vorzeichenlos, 1 = vorzeichenbehaftet
   Bit 4 ... 0: Anzahl der nachfolgenden Wertbytes: 1 = 8bit, 2 = 16bit, 4 = 32bit, 8 = 64bit; + 1, 2, 4 oder 8 Wertbytes (Little-Endian-Format); 64bit-Werte sind immer mit Vorzeichen Beispiel: 0x24, 0x79, 0x29, 0xed, 0xff → steht für: -1234567
b. Registerwert:
   Bit 7 ... 6: 01
   Bit 5 ... 3: 000 (unbenutzt)
   Bit 2 ... 0: Quellregister 0 ... 7
   Beispiel: 0x44 → steht für: R4
c. Diagnosedatenwert:
   Bit 7 ... 6: 10
   Bit 5 ... 4: Index der Diagnosedatenbeschreibung (4 unterschiedliche Diagnosedatenblöcke sind adressierbar)
   Bit 3 ... 0: Index des Wertes innerhalb der Diagnosedatenbeschreibung (nur die ersten 16 Werte sind adressierbar) Beispiel: 0xa8 → Diagnosedateblock[2].Wert[8] → Quelltextstatement: D[2].V[8]

### Weitere Argumenttypen:

a. Musterindex: Uint8
   Beispiel: 0x02 → writePatterns[2] → Quelltextstatement: P[2]
b. Offset: Uint8
   Ein Offset beschreibt den Sprung der Programmabarbeitung zu einer neuen Position im Programmcode. Im Quellcode wird ein Sprungziel mit einer Sprungmarke gekennzeichnet.
   Beispiel anhand der GOTO-Anweisung:

      ```
 GOTO newPosition
 ...
 NewPosition: ...
```

Auf eine Sprungmarke muss im Quelltext auf der gleichen Zeile eine Programminstruktion folgen.

### C. Text:

Erstes Byte: Anzahl der nachfolgenden Textzeichen Nachfolgende Bytes: ASCII-Textzeichen
Beispiel: 0x03 0x41 0x42 0x43 → Quelltextstatement: "ABC"
   - Im Quelltext sind Makrodefinitionen mit '#define' und Kommentare, markiert und beginnend mit '//', erlaubt.

**Tabelle mit Beispielen für mögliche Instruktionscodes:**

| Instruktion | Code | Argument (e) | Beschreibung |
|---|---|---|---|
| ASSIGN_R0 ... _R7 | 0x00 ... 0x07 | [src.arg.] | Zuweisung eines Quellarguments zu einem Register |
| ADD_R0 ... _R7 | 0x08 ... 0x0f | [src.arg.] | Rx := Rx + value |
| SUB_R0 ... _R7 | 0x10 ... 0x17 | [src.arg.] | Rx := Rx - value |
| MUL_R0 ... _R7 | 0x18 ... 0x1f | [src.arg.] | Rx := Rx * value |
| DIV_R0 ... _R7 | 0x20 ... 0x27 | [src.arg.] | Rx := Rx / value |
| AND_R0 ... _R7 | 0x28 ... 0x2f | [src.arg.] | Rx := Rx & value |
| OR_R0 ... _R7 | 0x30 ... 0x37 | [src.arg.] | Rx := Rx \| value |
| XOR_R0 ... _R7 | 0x38 ... 0x3f | [src.arg.] | Rx := Rx % value |
| NEG_R0 ... _R7 | 0x40 ... 0x47 | - | Rx := ~Rx |
| GT_R0 ... _R7 | 0x48 ... 0x4f | [src.arg.] [offset / Uint8] | IF Rx > value GOTO offset |
| LT_R0 ... _R7 | 0x50 ... 0x57 | [src.arg.] [offset / Uint8] | IF Rx < value GOTO offset |
| EQ_R0 ... _R7 | 0x58 ... 0x5f | [src.arg.] [offset / Uint8] | IF Rx == value GOTO offset |
| ACMD13_D0 ... _D3 | 0x60 ... 0x63 | - | Führe das ACMD13-Kommando aus and speichere die empfangenen Daten im Diagnosedatenblock 0 ... 3 |
| CMD56_D0 ... _D3 | 0x64 ... 0x67 | [src.arg.] | Führe das CMD56-Kommando mit dem gegebenen 32bit-Argument aus und speichere die empfangenen Daten im Diagnosedatenblock 0 ... 3 |
| WRITE_CMD56 | 0x68 | [pattern idx. / Uint8] [src.arg.] | Schreibe das Bitmuster mit dem CMD56-Kommando und dem gegebenen 32bit-Argument |
| WRITE_SEC | 0x69 | [pattern idx. / Uint8] [src.arg.] | Schreibe das Bitmuster auf die gegebene Sektoradresse |
| READ_SEC_D0 ... _D3 | 0x6a ... 0x6d | [src.arg.] | Lese einen Sektor und speichere die empfangenen Daten im Diagnosedatenblock 0 ... 3 |
| RAISE_ALARM | 0x6e | - | Melde einen Alarm (Lebensende der SD-Karte erreicht) |
| RAISE_WARNING | 0x6f | - | Melde eine Warnung, sofern noch kein (höherpriorer) Alarm gemeldet wurde (Lebensende der SD-Karte bald erreicht) |
| SET_OK | 0x70 | - | Setze den Status für die SD-Karte auf okay, sofern weder eine Warnung noch ein Alarm gemeldet wurde |
| GOTO | 0x71 | [offset / Uint8] | Setze die Programmabarbeit am der neuen Pro-grammposition fort |
| END | 0x72 | - | Beende die Programmausführung |
| CALLERROR | 0x73 | [text string] | Melde einen Fehlertext an das Diagnosesystem des Geräts |
| DELAY | 0x74 | [src.arg.] | Halte den Programmablauf für die gegebene Wartezeit in Microsekunden an |
| WRITE_SEC_D0 ... _D3 | 0x75 ... 0x78 | [src.arg.] | Schreibe einen der Diagnosedatenblöcke zurück auf die SD-Karte an die gegebene Zieladresse |

Das nachfolgende Beispielprogramm (dargestellt als Folge von Hexadezimalwerten) lädt zum Beispiel einen Diagnosedatenblock mittels ACMD13-Kommandos und prüft die Anzahl der Ersatzspeicherblöcke (spare blocks), die sich in diesem Beispiel im Wert Nr. 6 befinden:
[@00] 60 // Read health data with ACMD13 to description buffer 0
[@01] 00 86 // Register R0 := healthDataDescs[0].values[6 = spareBlockCount]
[@03] 48 01 05 09 // if R0 > 5 go to offset 0x09
[@07] 6e // Raise ALARM
[@08] 72 // End
[@09] 48 01 0a 0f // if R0 > 10 go to offset 0x0f
[@0d] 6f // Raise WARNING
[@0e] 72 // End
[@0f] 70 // Set OK

Die Referenzimplementierung verwendet vorzugsweise ein Compiler-Tool, mit dem sich einerseits die Beschreibungen der Diagnoseblöcke als auch der Programmcode in einer besser lesbaren Pseudosprache textbasiert entwickeln und in einen Binärdatenblock übertragen lässt.

Ein Programmcode-Beispiel in Textform für einen anderen SD-Kartentyp kann beispielsweise wie folgt aussehen:

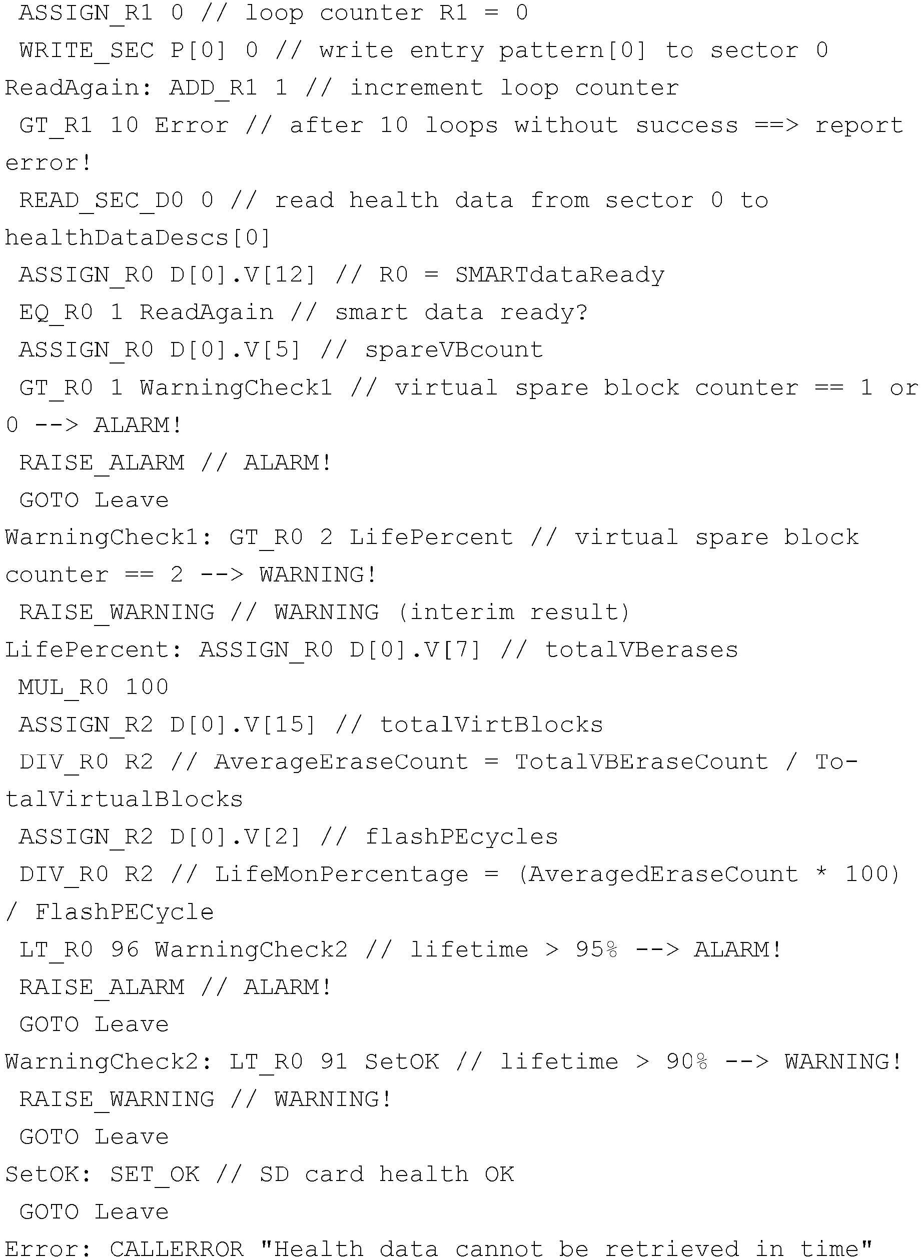

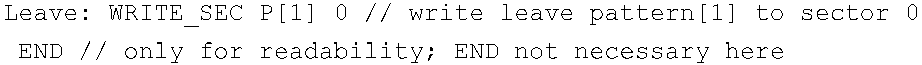

Folgendes Beispiel zeigt einen resultierenden Binärblock, der als Informationsdatensatz IDS im Rahmen eines Autorisierungs-/Produktionsschritts auf die SD-Karte geschrieben werden kann und alle notwenigen Beschreibungsdaten (auch die Texte für die Darstellung auf den Diagnoseseiten des Geräts) und den Bytecode zur Berechnung des Gesundheitsstatus der SD-Karte enthält:

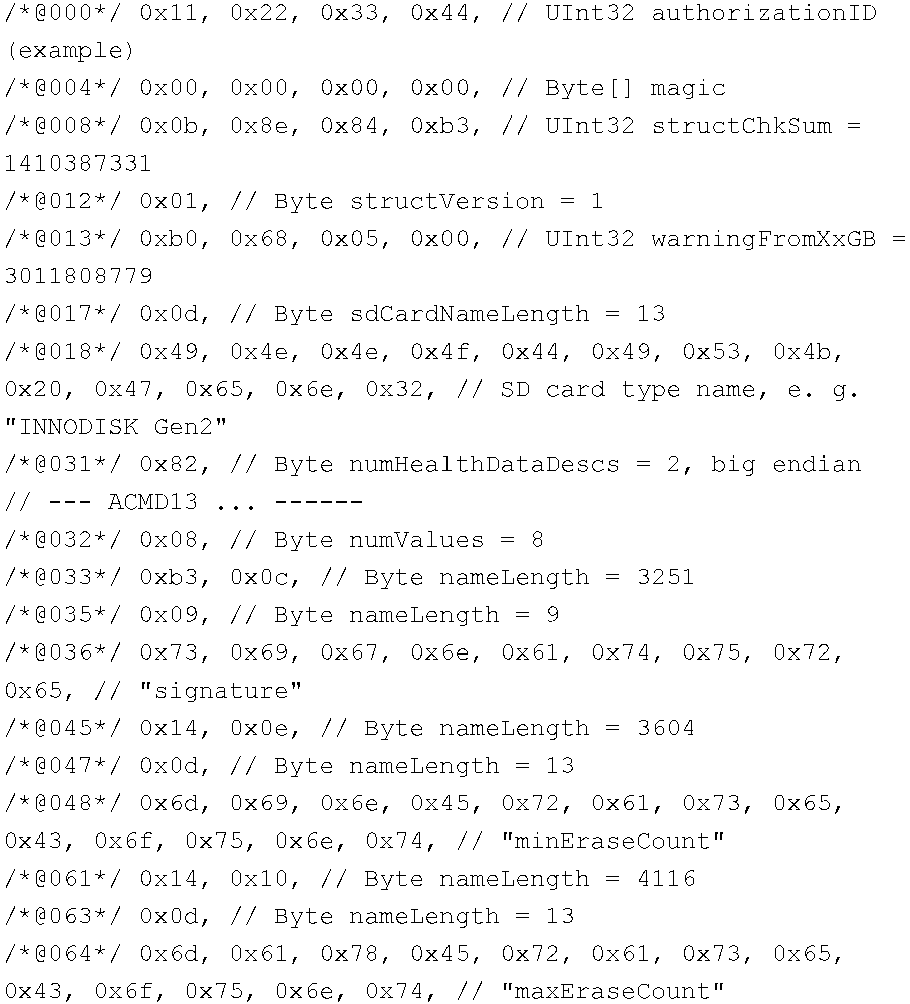

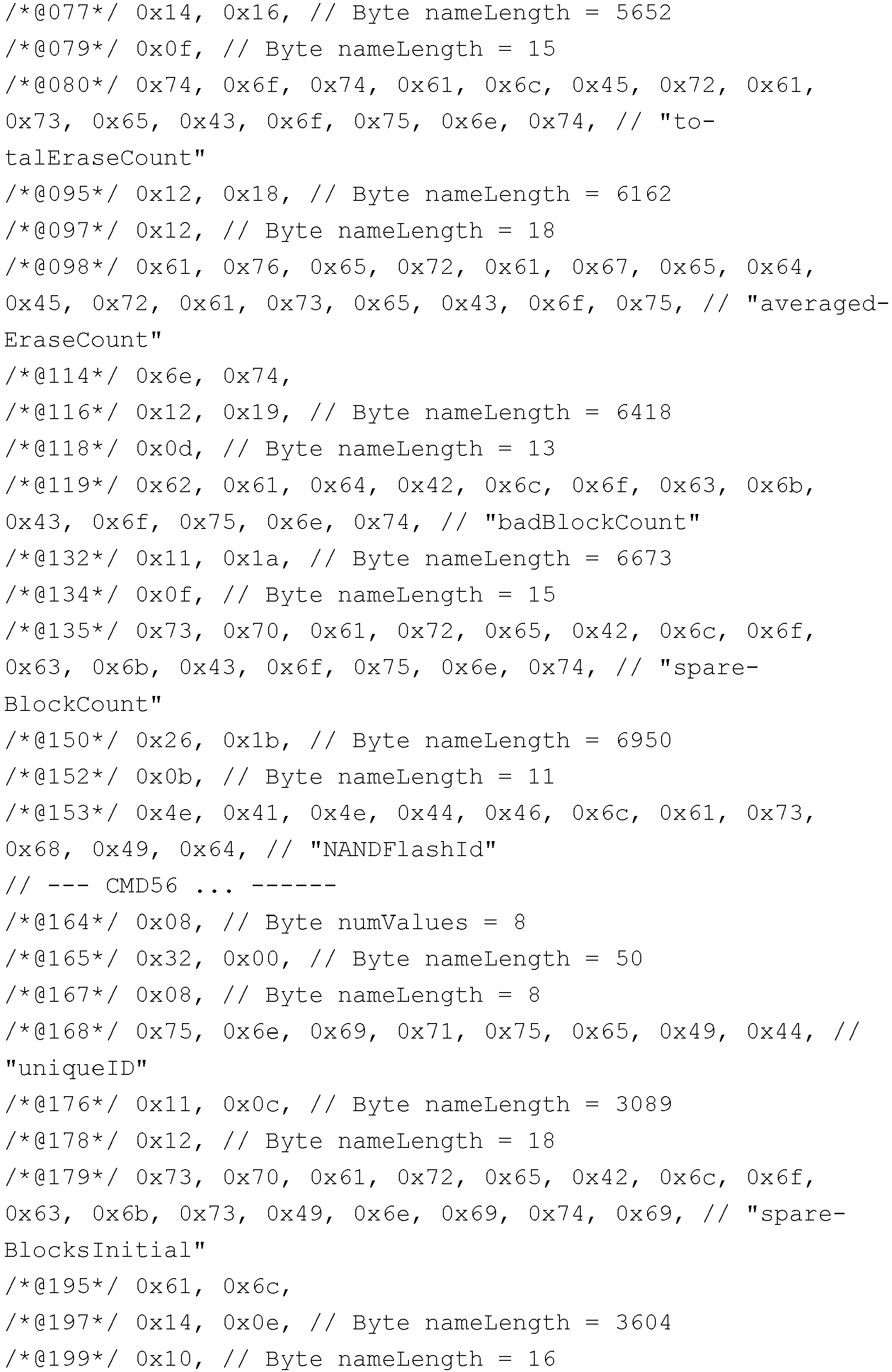

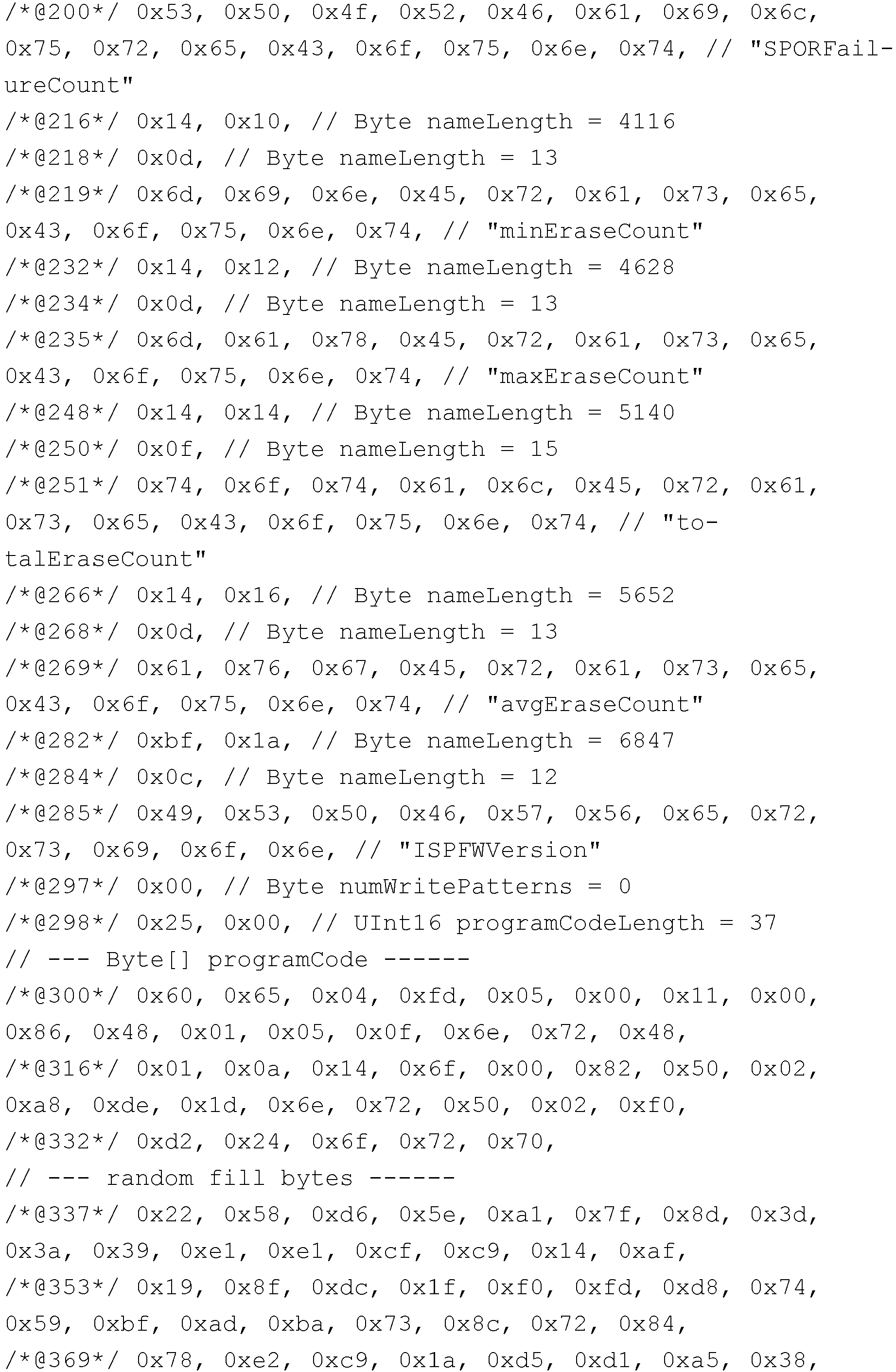

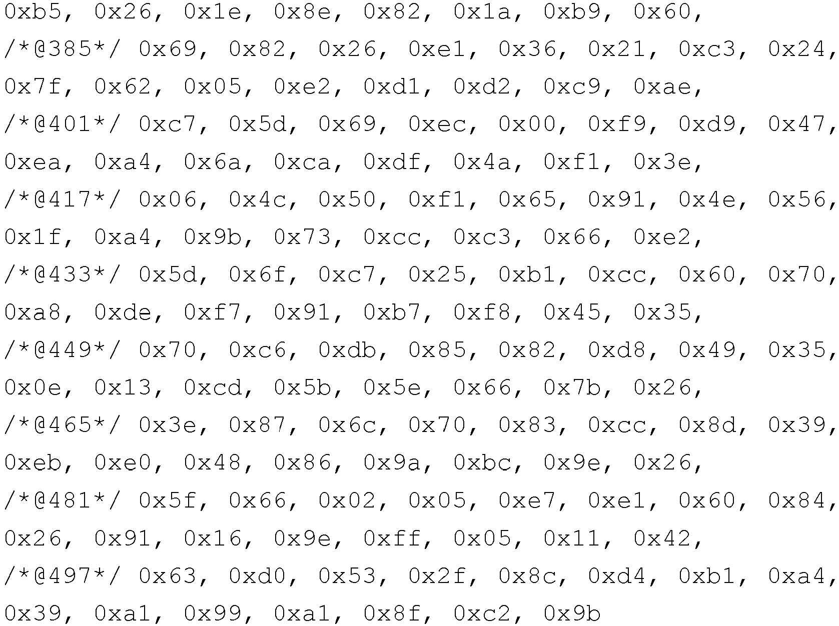

Damit dieser Beschreibungsblock von dem Gerät 10 verarbeitet werden kann, ist in dem Interpretationssoftwaremodul ISM vorzugsweise ein Interpreter als Unterfunktion implementiert, der die Datenbeschreibungen als Sektor von der SD-Karte einlesen und den Programmcode ausführen kann.

Im Gegensatz zu direkt ausführbarem Maschinencode stellt zu interpretierender Programmcode, wie er hier beschrieben wurde, mit seinen Beschränkungen auf Diagnosedaten kein Einfallstor für Schadsoftware dar.

Zusammengefasst lösen die oben beschriebenen Ausführungsbeispiele der Erfindung das Problem eines Einsatzes "unbekannter neuer Speicher" in "alten" Bestandsgeräten dadurch, dass auf den Speichern (z. B. SD-Karten) in einem oder mehreren unbenutzten Sektoren, die auf definierten Sektoradressen liegen, generische Informationen hinterlegt werden, die den Zugriff auf die benötigten Diagnoseinformationen beschreiben, einschließlich eines Algorithmus, der interpretativ ausgeführt wird, um die Restlebensdauer und damit den aktuellen Gesundheitszustand der SD-Karte berechnen zu können.

Ist also beispielsweise ein SD-Kartentyp, der in einem Gerät zum Einsatz kommt, nicht mehr verfügbar, kann das Gerät mit einem neuen Typ von SD-Karte eines beliebigen anderen Herstellers bestückt werden, ohne dass für den Zugriff auf die herstellerspezifischen Diagnosedaten die Gerätesoftware angepasst und in die im Feld im Einsatz befindlichen Geräte eingespielt werden muss. Auch für SD-Kartentypen, die zum Zeitpunkt der Implementierung der Gerätesoftware unbekannt waren, können über das beschriebene generische Verfahren also eine Lebensdauerschätzung und daraus abgeleitete Warnungen und Alarme erfolgen.

Die oben beschriebenen generischen Verfahren berücksichtigen, dass der Hersteller eines SD-Kartentyps Vorgaben zum Algorithmus machen kann, mit dem die Restlebensdauer auf Basis der bereitgestellten Diagnosedaten berechnet werden kann. Die oben beschriebenen Verfahren zeichnen sich dadurch aus, dass sie so gestaltet werden können, dass sie nicht als Einfallstor für Schadcode missbraucht werden können.

Abschließend sei erwähnt, dass im Rahmen der in den unabhängigen Ansprüchen spezifizierten Erfindung die Merkmale aller oben beschriebenen Ausführungsbeispiele untereinander in beliebiger Weise kombiniert werden können, um weitere andere Ausführungsbeispiele der Erfindung zu bilden.

Auch können im Rahmen der in den unabhängigen Ansprüchen spezifizierten Erfindung alle Merkmale von Unteransprüchen jeweils für sich mit jedem der nebengeordneten Ansprüche kombiniert werden, und zwar jeweils für sich allein oder in beliebiger Kombination mit einem oder mehreren anderen Unteransprüchen, um weitere andere Ausführungsbeispiele zu erhalten.

## Patentansprüche

1. Verfahren zum Initialisieren eines Speichers (20) , wobei ein auf dem Speicher (20) gespeicherter Informationsdatensatz (IDS) ausgelesen und interpretiert wird, wobei folgende Informationen gewonnen werden:
- Informationen über die Art an Diagnosedaten (DD), die der Speicher (20) bei externer Anfrage zur Verfügung stellt,
- Informationen über das erforderliche Anfrageprozedere für solche externen Anfragen und
- Auswertinformationen, die eine Interpretation der vom Speicher (20) auf Anfrage gelieferten Antwortdaten ermöglichen.

2. Gerät (10), das eine Schnittstelle zum Anschluss an einen Speicher (20) aufweist, wobei in dem Gerät (10) ein Interpretationssoftwaremodul (ISM) abgespeichert ist, das bei Ausführung durch eine Recheneinrichtung (12) des Geräts das Gerät (10) veranlasst, einen in einem angeschlossenen Speicher (20) abgespeicherten Informationsdatensatz (IDS), der Informationen über die Art an Diagnosedaten (DD), die der Speicher (20) bei externer Anfrage zur Verfügung stellt, Informationen über das erforderliche Anfrageprozedere für solche externen Anfragen und Auswertinformationen, die eine Interpretation der vom Speicher (20) auf Anfrage gelieferten Antwortdaten ermöglichen, enthält, auszulesen und zumindest hinsichtlich des Anfrageprozedere und der Interpretation der Antwortdaten auszuwerten.

3. Gerät (10) nach Anspruch 2,
**dadurch gekennzeichnet, dass**
das Interpretationssoftwaremodul (ISM) Bitsequenzen (BSZ) und/oder eine Anfragebefehlskette (AFK) aus dem Informationsdatensatz (IDS) ausliest und diese anschließend abarbeitet, um die Diagnosedaten (DD) aus dem Speicher (20) abzufragen.

4. Gerät (10) nach einem der Ansprüche 2 oder 3,
**dadurch gekennzeichnet, dass**
das Interpretationssoftwaremodul (ISM) aus dem Informationsdatensatz (IDS) Interpretationsinstruktionen ausliest und diese anschließend abarbeitet, um die ausgelesenen Diagnosedaten (DD) zu interpretieren und speicherseitig empfohlene Maßnahmen (M) durchzuführen.

5. Gerät (10) nach einem der voranstehenden Ansprüche 2 bis 4,
**dadurch gekennzeichnet, dass**
das Gerät (10) Beschreibungsinformationen (BI) des Informationsdatensatzes (IDS) bei bedienerseitiger Aufforderung visuell, haptisch und/oder akustisch ausgibt und/oder eine Fernabfrage der Beschreibungsinformationen (BI) ermöglicht.

6. Gerät (10) nach einem der voranstehenden Ansprüche 2 bis 5,
**dadurch gekennzeichnet, dass**
das Gerät (10) ein energietechnisches Schutz- und/oder Beobachtungsgerät, insbesondere ein Leittechnikgerät, ein Störschreiber oder eine Einrichtung zur Überwachung der Netzqualität, für eine elektrische Energieversorgungsanlage ist.

## Claims

1. Method for initializing a memory (20),
wherein
an information data set (IDS) stored in the memory (20) is read out and interpreted, wherein the following information is obtained:
- information about the type of diagnostic data (DD) made available by the memory (20) upon external request,
- information about the required request procedure for such external requests and
- evaluation information enabling an interpretation of the answer data supplied by the memory (20) on request.

2. Device (10) having an interface for connection to a memory (20),
wherein
an interpretation software module (ISM) is stored in the device (10) and, upon execution by a computing unit (12) of the device, causes the device (10) to read out an information data set (IDS) stored in a connected memory (20), said information data set containing information about the type of diagnostic data (DD) made available by the memory (20) upon external request, information about the required request procedure for such external requests and evaluation information enabling an interpretation of the answer data supplied by the memory (20) on request, and to evaluate said information data set at least with regard to the request procedure and the interpretation of the answer data.

3. Device (10) according to Claim 2,
**characterized in that**
the interpretation software module (ISM) reads out bit sequences (BSZ) and/or a request command chain (AFK) from the information data set (IDS) and subsequently processes same in order to retrieve the diagnostic data (DD) from the memory (20).

4. Device (10) according to either of Claims 2 and 3,
**characterized in that**
the interpretation software module (ISM) reads out interpretation instructions from the information data set (IDS) and subsequently processes them in order to interpret the diagnostic data (DD) read out and to implement measures (M) recommended on the part of the memory.

5. Device (10) according to any of the preceding Claims 2 to 4,
**characterized in that**
the device (10) visually, haptically and/or acoustically outputs description information (BI) of the information data set (IDS) when requested by the operator and/or enables a remote retrieval of the description information (BI).

6. Device (10) according to any of the preceding Claims 2 to 5,
**characterized in that**
the device (10) is a power engineering protection and/or observation device, in particular a control engineering device, a fault recorder or a unit for monitoring the network quality, for an electrical power supply system.

## Revendications

1. Procédé d'initialisation d'une mémoire (20),
dans lequel
on lit et on interprète un ensemble (IDS) de données d'information mis en mémoire sur la mémoire (20), dans lequel on obtient des informations suivantes :
- informations sur le type de données (DD) de diagnostic que la mémoire (20) met à disposition, s'il y a des demandes extérieures,
- informations sur les procédures de demandes nécessaires pour de telles demandes extérieures et
- informations d'évaluation, qui permettent une interprétation des données de réponse fournie sur demande par la mémoire (20).

2. Appareil (10), qui a une interface de connexion à une mémoire (20),
dans lequel
dans l'appareil (10), est mis en mémoire un module (ISM) de logiciel d'interprétation, qui, lors de l'exécution par un dispositif (12) informatique de l'appareil, fait que l'appareil (10) contient, lit et, au moins en ce qui concerne la procédure de demande et l'interprétation, évalue les données de réponse, un ensemble (IDS) de données d'information, mis en mémoire dans une mémoire (20) raccordée, qui contient des informations sur le type de données (DD) de diagnostic que la mémoire (20) met à disposition, s'il y a une demande extérieure, des informations sur la procédure nécessaire de demande pour de telles demandes extérieures et des informations d'évaluation, qui permettent une interprétation des données de réponse fournies sur demande par la mémoire (20).

3. Appareil (10) suivant la revendication 2,
**caractérisé en ce que**
le module (ISM) de logiciel d'interprétation lit des séquences (BSZ) de bits et/ou une chaîne (AFK) d'instructions de demandes de l'ensemble (IDS) de données d'information et les élabore ensuite afin de demander les données (DD) de diagnostic de la mémoire (20).

4. Appareil (10) suivant l'une des revendications 2 ou 3,
**caractérisé en ce que**
le module (ISM) de logiciel d'interprétation lit, à partir de l'ensemble (IDS) de données d'information, des instructions d'interprétation et les élabore ensuite afin d'interpréter les données (DD) de diagnostic lues et de prendre des mesures (M) recommandées du côté de la mémoire.

5. Appareil (10) suivant l'une des revendications 2 à 4 précédentes,
**caractérisé en ce que**
l'appareil (10) donne visuellement, haptiquement et/ou acoustiquement des informations (BI) de description de l'ensemble (IDS) de données d'information sur invitation par l'opérateur et/ou permet une demande à distance des informations (BI) de description.

6. Appareil (10) suivant l'une des revendications 2 à 5 précédentes,
**caractérisé en ce que**
l'appareil (10) est un appareil de protection en technique d'énergie et/ou un appareil d'observation, en particulier un appareil technique de conduite, un enregistreur de perturbation, un dispositif de contrôle de la qualité d'un réseau, pour une installation d'alimentation en énergie électrique.
